# EUROPEAN PATENT APPLICATION

(11) **EP 3 093 763 A1**
(43) Date of publication of application: **16.11.2016**
(21) Application number: 16150477.4
(22) Date of filing: 07.01.2016
(51) Int. Cl.: G06F 11/10, G11C 29/00

(54) **DIAGNOSTIC PROGRAM, DIAGNOSTIC METHOD, AND SEMICONDUCTOR DEVICE**

(30) Priority: 25.03.2015 JP 2015062687
(71) Applicant: Renesas Electronics Corporation, Tokyo 135-0061 (JP)
(72) Inventor: YAMATE, Akihiro, Tokyo, 135-0061 (JP); TAKI, Yoshitaka, Tokyo, 135-0061 (JP)
(74) Representative: Addiss, John William

(57) **Abstract**

In a memory with ECC, a failure detection rate of an address circuit of the memory is improved without using address information to generate redundant bits and without rewriting the memory.

The memory stores data of addresses different from each other and redundant bits added to the data in a plurality of memory cells sharing the same selection signal wiring (for example, a word line or a column line) and outputs read-out data corresponding to a specified address. An ECC decoder performs error detection on the read-out data. When an error is detected by the ECC decoder, a failure diagnosis of the memory is performed by accessing one or a plurality of addresses which are selected by the same selection signal wiring as selection signal wiring that selects read-out data where the error is detected and which are different from the address of the read-out data and evaluating a result of the error detection for the read-out data.

## Description

The disclosure of Japanese Patent Application No. 2015-062687 filed on March 25, 2015 including the specification, drawings and abstract is incorporated herein by reference in its entirety.

The present invention relates to a diagnostic program and a diagnostic method for failure of memory and a semiconductor device where the memory is mounted. In particular, the present invention is preferably used for failure diagnosis of address circuit.

In related art, as a countermeasure against a failure of memory, implementation of an ECC (Error Correction Code) circuit is widely known. For example, redundant bits generated by an error correction algorithm of SEC/DED (Single Error Correction / Double Error Detection) are added to data to be written and the data is written to a memory, it is determined whether there is no error or there is a one-bit error or a two-bit error from read-out main body data and redundant bits, and if there is a one-bit error, the one-bit error is corrected. At this time, when redundant bits are generated from data and the redundant bits are added to the data, it is possible to deal with a failure of a data circuit, and when redundant bits are generated from both address and data and the redundant bits are added to the address and the data, it is possible to deal with not only a failure of the data circuit but also a failure of the address circuit.

Each of Japanese Unexamined Patent Application Publication No. 2006-139498 and Freescale Semiconductor Inc., "Safety Manual for MPC5744P", U.S.A., 2014/06, Rev. 3, page 148-151 discloses a failure diagnostic circuit of a memory and an algorithm thereof, which use not only data information but also address information for calculation of redundant bits of ECC by considering not only a failure of data circuit but also a failure of address circuit.

The inventors have studied Japanese Unexamined Patent Application Publication No. 2006-139498 and Freescale Semiconductor Inc., "Safety Manual for MPC5744P", U.S.A., 2014/06, Rev. 3, page 148-151. As a result, the inventors have found that there are new problems as described below.

Not only data information but also address information is used for a calculation of redundant bits of ECC, so that the number of redundant bits is large and the code length is long because the code includes not only the redundant bits but also the address information. Therefore, a calculation load required for the error determination and correction processing is heavy. When the error determination and correction processing is performed by software, the number of execution cycles is large, and when dedicated hardware that performs such processing is provided, the circuit scale is large and calculation delay is also large. Further, it is found that there is the following problem in capability to detect a failure of an address circuit.

As failure modes of the address circuit, there are non-selection, multiple selection, and mis-selection of address. It is found that, among them, a circuit that causes the failure mode of mis-selection is very small and a circuit that causes the failure modes of non-selection and multiple selection is dominant. For example, the circuit scale of a word line decoder that causes non-selection and multiple selection of word line when a failure occurs is about 110 times the circuit scale of an address latch that causes mis-selection. Therefore, from a viewpoint of improving a detection rate, it is found that a countermeasure against the non-selection and multiple selection is more important than a countermeasure against the mis-selection. On the other hand, it is found that the related art is effective as a countermeasure against the mis-selection but is not sufficient as a countermeasure against the non-selection and multiple selection and the related art is not necessarily an effective means. There is a March test on address bits to detect the failure modes of non-selection and multiple selection of an address circuit. However, during the March test, data in the memory needs to be rewritten, so that it is necessary to limit access to a memory area where the data is rewritten from another master module. Because of the limitation to the access, it is not preferable to apply the March test to a customer application.

While the means considered in the light of the above problems will be described below, the other purposes and the new features will become clear from the description of the present specification and the accompanying drawings.

An embodiment of the invention is as follows.

The embodiment is a diagnostic method of diagnosing a failure of a memory to which an ECC decoder is coupled, a program for a processor that can access the memory to perform the diagnostic method, a circuit to perform the diagnostic method, or a semiconductor device in which these are implemented and is configured as described below. The memory stores data of addresses different from each other and redundant bits added to the data in a plurality of memory cells sharing the same selection signal wiring (for example, a word line or a column line) and outputs data corresponding to a specified address and redundant bits added to the data as read-out data. The ECC decoder performs error detection on the read-out data. When an error is detected by the ECC decoder, a failure diagnosis of the memory is performed by reading out data stored in one or a plurality of addresses which are selected by the same selection signal wiring as selection signal wiring that selects read-out data where the error is detected and which are different from the address of the read-out data and evaluating a result of error detection for the read out read-out data.

A brief description of the effects obtained from the embodiment is as follows.

In a memory to which an ECC decoder is coupled, it is possible to improve a failure detection rate of an address circuit of the memory without using address information to generate redundant bits and without rewriting the memory.

In the drawings:
Fig. 1 is a flowchart showing a failure diagnosis flow of a first embodiment.
Fig. 2 is a block diagram showing a configuration example of a memory which is an object of the failure diagnosis.
Fig. 3 is a circuit diagram showing a configuration example of an address decoder which is an object of the failure diagnosis.
Fig. 4 is an illustration showing a failure mode assumed in the address decoder in Fig. 3.
Fig. 5 is a circuit diagram showing a configuration example of a column selector of the memory which is an object of the failure diagnosis.
Fig. 6 is a flowchart showing a failure diagnosis flow of a second embodiment.
Fig. 7 is a flowchart showing a failure diagnosis flow of a third embodiment.
Fig. 8 is a block diagram showing an implementation example of a memory test circuit of a fifth embodiment.

Embodiments will be described in detail. Components having the same function are denoted by the same reference symbols throughout the drawings for describing the embodiments, and the repetitive description thereof will be omitted.

### First Embodiment

### Read-out from a plurality of addresses sharing the same word line

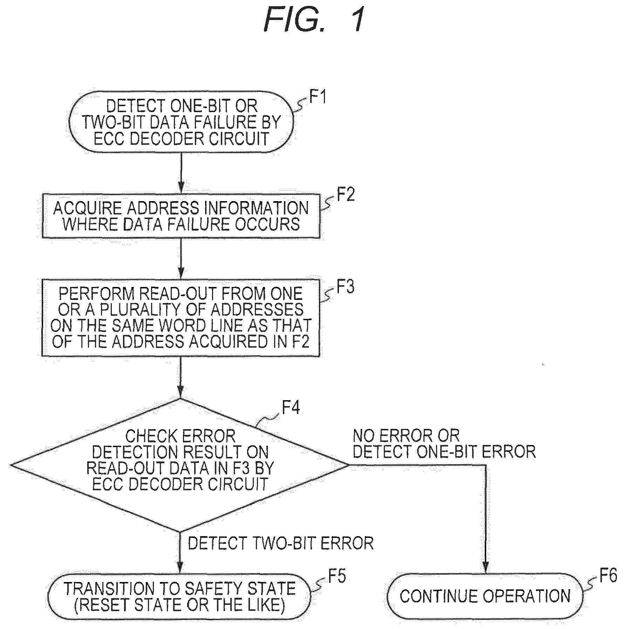

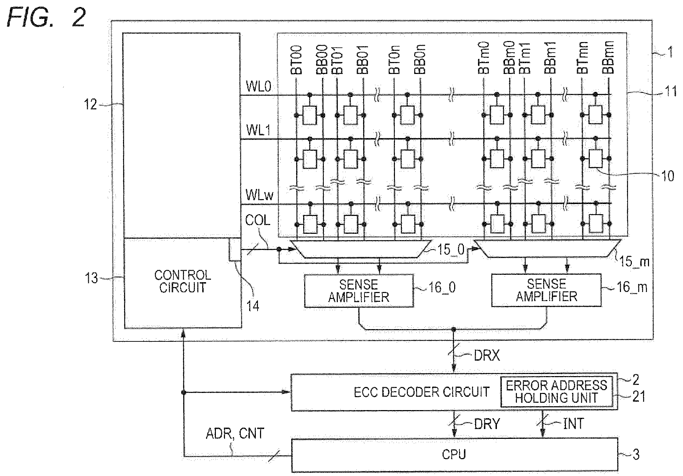

Fig. 1 is a flowchart showing a failure diagnosis flow of the first embodiment. Fig. 2 is a block diagram showing a configuration example of a memory which is an object of the failure diagnosis.

As shown in Fig. 2, a memory 1 which is an object of the failure diagnosis is coupled to an ECC decoder circuit 2 and a CPU (Central Processing Unit) 3. An address ADR and a control signal CNT are supplied from the CPU 3. Read-out data DRX which includes a data main body and redundant bits and which is read out from the memory 1 is inputted into the ECC decoder circuit 2. ECC-processed read-out data DRY and an interrupt signal INT that notifies of an error are outputted to the CPU 3. An error correction algorithm employed by the ECC decoder circuit 2 is, for example, SEC/DED. When there is no error in the read-out data DRX, the ECC decoder circuit 2 outputs a main body data part of the read-out data DRX to the CPU 3 as the read-out data DRY. When there is a one-bit error in the read-out data DRX, the ECC decoder circuit 2 outputs corrected main body data of the read-out data DRX to the CPU 3 as the read-out data DRY and at the same time notifies the CPU 3 that the one-bit error is detected by using the interrupt signal INT. When a two-bit error is detected in the read-out data DRX, the error cannot be corrected by the SEC/DED, so that the ECC decoder circuit 2 notifies the CPU 3 that the two-bit error is detected by using the interrupt signal INT. The read-out data DRY at this time is, for example, uncorrected main body data. The ECC decoder circuit 2 is configured to include an error address holding unit 21 and hold information of an address where the read-out data from which an error is detected is stored so that the information of the address can be read by the CPU 3.

The memory 1 includes a memory mat 11, a word line decoder circuit 12, a control circuit 13 including a column line decoder circuit 14, column selectors 15_0 to 15_m, and sense amplifiers 16_0 to 16_m. The word line decoder circuit 12 includes a word line driver circuit and the column line decoder circuit 14 includes a column line driver circuit. The memory mat 11 includes a plurality of memory cells 10 arranged in a matrix shape of w+1 rows and (m+1) × (n+1) columns. The memory cells in each row are coupled to each of the word lines WL0 to WLw. The memory cells in each column are coupled to one sense amplifier 16 through one column selector 15 for each group of n+1 columns. Here, n+1 pairs of bit line pairs BT00/BB00 to BT0n/BB0n are coupled to the column selector 15_0 shown in Fig. 2. The column selector 15_0 selects one pair of bit line pair selected by a column line COL and inputs the selected bit line pair to the sense amplifier 16_0. In the same manner, n+1 pairs of bit line pairs BTm0/BBm0 to BTmn/BBmn are coupled to the column selector 15_m. The column selector 15_m selects one pair of bit line pair selected by the column line COL and inputs the selected bit line pair to the sense amplifier 16_m. Here, although not limited in particular, the memory cell 10 is a memory cell of SRAM (Static Random Access Memory) including six transistors, the bit line pair BT and BB are bit lines in a mutually complementary relationship, and the sense amplifier 16 is a differential sense amplifier. The word line decoder circuit 12 decodes a part of a plurality of bits of the address ADR to cause one of the word lines WL0 to WLw to be asserted, selects a plurality of memory cells 10 coupled to the one word line, and reads out information stored in each memory cell to a bit line pair coupled to the memory cell. The column line decoder circuit 14 decodes the other part of the plurality of bits of the address ADR to output the column line COL, and the column selector 15 selects one bit line pair selected by the column line COL to electrically couple the one bit line pair to the sense amplifier 16. The column line COL is, for example, a one-hot decode signal that includes a plurality of signal lines in the same manner as the word line. Here, "asserted" is a state in which a memory cell is selected, and when a memory cell is selected in positive logic, the "asserted" is high level in a digital logic. On the contrary, "negated" is a state in which a memory cell is not selected, and the "negated" is low level in positive logic. The one-hot indicates a configuration in which only one of a plurality of selection signal lines is asserted and the other signal lines are negated.

The memory 1 is configured as described above, so that the memory 1 functions as a memory of (w+1)×(n+1) words × (m+1) bits. A plurality of memory cells selected by one word line include n+1 words, that is, data of n+1 addresses. One word of the n+1 words is selected by the column selector 15, converted into a digital signal by the sense amplifier 16, and outputted as the read-out data DRX.

In a normal operation, one of the word lines WL0 to WLw is asserted as described above. When there is a failure in the word line decoder circuit 12, a failure mode such as multiple selection, non-selection, and mis-selection appears. Here, the multiple selection is a state in which a plurality of word lines are asserted at the same time. The non-selection is a state in which all the word lines are negated. The mis-selection is a state in which a word line to be asserted is negated and another word line is asserted. Similarly, in a normal operation, one bit line pair specified by the column line COL is selected, and when there is a failure in the column line decoder circuit 14, a failure mode such as multiple selection, non-selection, and mis-selection appears.

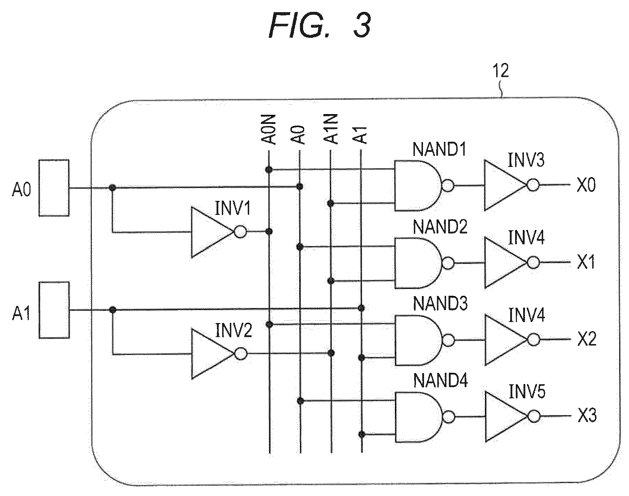

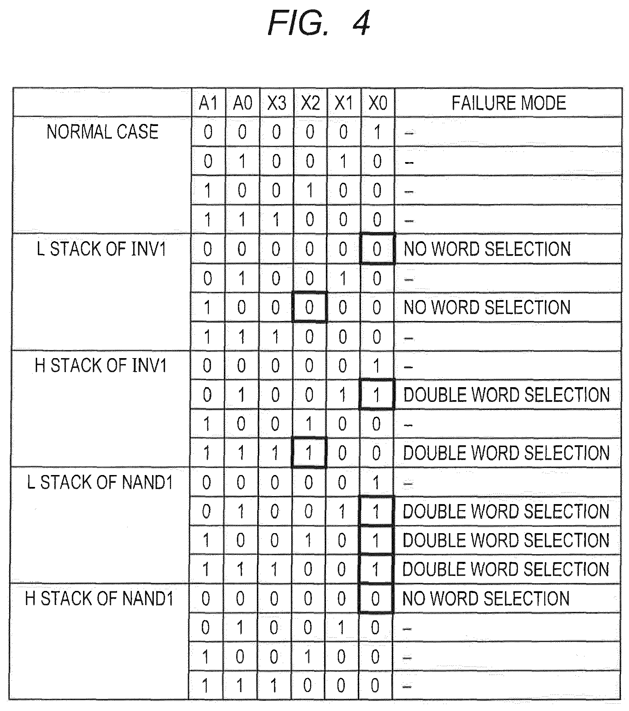

A failure position in an address decoder circuit and a failure mode that appears will be described. Fig. 3 is a circuit diagram showing a configuration example of an address decoder which is an object of the failure diagnosis. Fig. 4 is an illustration showing a failure mode assumed in the address decoder in Fig. 3. To facilitate understanding, as the address decoder circuit, the word line decoder 12 to which two-bit address A0 and A1 is inputted and from which four word lines X0 to X3 are outputted is illustrated. However, the number of input/output bits is arbitrarily determined and the same goes for the column line decoder 14. The word line decoder 12 includes two inverters INV1 and INV2 that generate negative logic signals A0N and A1N respectively for the two-bit address A0 and A1 and four pairs of a NAND gate and an inverter, which include a pair of NAND1 and INV3, a pair of NAND2 and INV4, a pair of NAND3 and INV5, and a pair of NAND4 and INV6 and which generate word line outputs X0 to X3.

Fig. 4 shows a normal operation (Normal case) and five failure positions. In each case, a truth table where A0 and A1 are inputs and X0 to X3 are outputs and a failure mode at that time are shown. In the normal operation (Normal case), one of the word lines X0 to X3 is asserted according to an inputted address A0 and A1. If an output of INV1 is fixed to low (L stack of INV1), when A1 = 0 and A0 = 0, and X0 = 1 should be asserted, X0 = 0 is outputted, so that the failure mode is non-selection (no word selection), and when A1 = 1 and A0 = 0 , and X2 = 1 should be asserted, X2 = 0 is outputted, so that the failure mode is also non-selection (no word selection). If the output of INV1 is fixed to high (H stack of INV1), when A1 = 0 and A0 = 1, and X0 should be negated, X0 = 1 is outputted, so that the failure mode is double selection (double word selection), and when A1 = 1 and A0 = 1, and X2 should be negated, X2 = 1 is outputted, so that the failure mode is also double selection (double word selection) . If an output of NAND1 is fixed to low (L stack of NAND1), X0 = 1 is outputted at all times regardless of address A0 and A1, so that the failure mode is double selection (double word selection) at all times other than when A1 = 0 and A0 = 0. On the other hand, if the output of NAND1 is fixed to high (H stack of NAND1), X0 = 0 is outputted at all times regardless of address A0 and A1, so that the failure mode is non-selection (no word selection) when A1 = 0 and A0 = 0. The same goes for the other logic gates INV2 , NAND2 , NAND3 , NAND4 , and INV3 to INV5 , so that the description thereof will be omitted. In this way, the non-selection (no word selection) and the multiple selection (multi-word selection) such as the double selection (double word selection) occur. However, mis-selection rarely occurs. Specifically, the mis-selection occurs only when two or more failures occur in the address decoder circuit or an address value itself that is inputted into the address decoder is erroneous.

In the memory 1 as shown Fig. 2, when a failure such as multiple selection and non-selection of word lines occurs, the read-out data DRX becomes random data. When multiple word lines are selected, data from a plurality of memory cells 10 are read out to each bit line pair BT/BB, so that signal collision occurs and the read-out data DRX becomes random data. In the case of non-selection, each bit line pair BT/BB is not driven from any memory cell 10 . At this time, each bit line pair BT/BB is normally precharged to the same potential by a precharge circuit not shown in the drawings and its precharge level is maintained because the bit line pair BT/BB is not driven from any memory cell 10 and is directly inputted into the sense amplifier 16. The sense amplifier 16 is a differential amplifier circuit, so that when BT and BB without potential difference are inputted, the sense amplifier 16 outputs random data. Here, as described above, a plurality of memory cells selected by one word line include n+1 words, that is, data of n+1 addresses. Therefore, the influence of multiple selection failure and non-selection failure of word line affects the read-out data DRX of a plurality of addresses.

On the other hand, an ECC circuit of SEC/DED for 32-bit data generally used in an MCU (Micro Controller Unit) and the like recognizes about 32% of random data as a one-bit failure, so that there is a risk of erroneous correction. The possibility to recognize the random data as a two-bit failure is nearly 68% and the probability not to recognize the random data as a failure is very small to be 1% or less.

Based on the above, Fig. 1 shows a flowchart showing a failure diagnosis flow of the first embodiment. The failure diagnosis flow is performed by, for example, the CPU 3. The failure diagnosis flow of the first embodiment starts from F1 where the ECC decoder circuit 2 detects one-bit or two-bit data failure (error). In other words, the failure diagnosis flow is started by an interrupt INT. The failure diagnosis flow is not limited to be started from detection of a data failure by the interrupt signal INT, but may be started by a software interrupt that detects a data failure by periodic polling operations.

Subsequently, in F2, the error address holding unit 21 acquires address information where the data failure (error) occurs. The multiple selection and non-selection of word lines affects a plurality of addresses on the same word line, so that in F3, read-out is performed from N different addresses on the same word line as that of the address acquired in F2. Thereafter, in F4, an error detection result of the ECC decoder circuit 2 on the read-out data DRX in F3 is checked. Here, N is an integer greater than or equal to 1 and smaller than or equal to n+1.

When no error is detected in F4, the probability that the ECC decoder circuit 2 of SEC/DED does not recognize the random data as a failure is very small to be 1% or less, so that it is determined that the error detected in F1 is a non-reproducible temporary failure. Subsequently, when only a one-bit data failure is detected in F4, the error detected in F1 is a one-bit error that can be corrected by the ECC decoder circuit 2 of SEC/DEC. This is because the probability that the ECC decoder circuit 2 of SEC/DEC recognizes the random data as a one-bit failure by one-time read-out is 32% and the probability that the ECC decoder circuit 2 of SEC/DEC continuously recognizes the random data as a one-bit failure by a plurality of times of read-out is very small to be the Nth power of 32%. For example, when N is 5, the probability is 0.34% or less. In the cases of no error and one-bit data failure, the operation can be continuously performed, so that the operation proceeds to "Continue operation" in F6.

On the other hand, when once the ECC decoder circuit 2 of SEC/DEC recognizes a two-bit data failure, the error detected in F1 is a failure that cannot be corrected by the ECC decoder circuit 2 of SEC/DEC including random data and it is not possible to continue the operation. In this case, the state of the MCU is transitioned to a safety state. Although the definition of the safety state varies according to a system, the safety state is a reset state of the MCU, a state in which an error has been notified to the system, and the like. When a two-bit data failure (error) is detected in F1, it is possible to proceed to the safety state of F5 instead of proceeding to F2.

Thereby, it is possible to improve a failure detection rate of an address circuit of a memory without using address information to generate redundant bits and without rewriting the memory. As a result, it is possible to detect a failure of an address circuit such as the word line decoder circuit 12 at a high detection rate of over 99%. Here, it is possible to appropriately adjust the value of the integer N by considering a balance between a required detection rate and a load of the system. Even when the number of addresses selected by one word line is n+1, it is not necessary to perform read-out on all the addresses in F3. The value of the integer N may be appropriately set so as to satisfy the required detection rate.

Fig. 2 shows an example of the memory 1 which includes memory cells of SRAM including six transistors, complementary bit line pairs BT/BB, and differential sense amplifiers 16. However, it is possible to apply the failure diagnosis flow of the first embodiment shown in Fig. 1 to another memory including one bit line instead of the bit line pair and single-end sense amplifiers. The single-end sense amplifier outputs a digital value by determining a read-out level by generally comparing one bit line level and a fixed reference voltage defined by a reference current. In general, the bit line is often precharged in advance, so that if a non-selection failure of a word line occurs, each bit of the read-out data DRX including main body data and redundant bits has the same value regarding not only the main body data but also the redundant bits. In this case, an error correction code is assigned so that the ECC decoder circuit 2 can handle the read-out data DRX at this time as an uncorrectable error. When a multiple selection failure of a word line occurs, in the same manner as in the case of the differential sense amplifier, the read-out data DRX becomes random data. Thereby, also in the case of a non-differential single-end sense amplifier, in the same manner, it is possible to improve the failure detection rate of the address circuit by applying the failure diagnosis flow of the first embodiment. Specifically, the memory 1 is not limited to the SRAM as shown in Fig. 2, and it is also possible to apply the failure diagnosis flow of the first embodiment to a nonvolatile memory such as a DRAM (Dynamic Random Access Memory) and a flash memory and a ROM (Read Only Memory).

Fig. 2 shows an example in which the ECC decoder circuit 2 includes the error address holding unit 21. However, the ECC decoder circuit 2 need not necessarily include the error address holding unit 21. The address where an error is detected is an address accessed from a normal application program executed by the CPU 3, so that when the CPU 3 accepts an interrupt notifying that the error occurs, the CPU 3 is in a state of waiting for read-out data corresponding to the address. Therefore, by delivering the address value of the memory access at that time to the failure diagnosis flow, it is possible to perform the failure diagnosis flow of Fig. 1 even when the error address holding unit 21 of hardware is not included. On the other hand, when the error address holding unit 21 is included in the ECC decoder circuit 2 and the address value can be read out from the CPU 3 that performs the failure diagnosis flow, it is not necessary to deliver the address value to an interrupt processing routine and it is possible to improve the independence of the interrupt processing routine where the failure diagnosis flow is implemented.

### Second Embodiment

### Read-out from a plurality of addresses sharing the same column line

While the failure diagnosis flow focusing attention on the word line decoder circuit 12 is described in the first embodiment, the failure diagnosis flow focusing attention on the column line decoder circuit 14 will be described in the second embodiment.

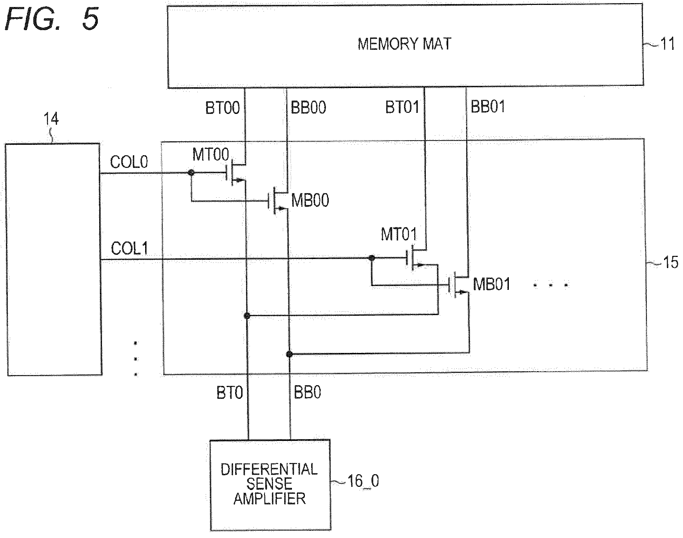

Fig. 5 is a circuit diagram showing a configuration example of a column selector 15 of the memory 1 which is an object of the failure diagnosis. To facilitate understanding, only a part is shown in Fig. 5 and the other is omitted. Therefore, Fig. 5 shows a column selector 15_0 and a sense amplifier 16_0 for one bit, two bit line pairs BT00/BB00 and BT01/BB01 inputted from the memory mat 11, and two column lines COL0 and COL1 inputted from the column line decoder circuit 14.

The column selector 15_0 includes switch transistors MT00, MB00, MT01, and MB01 corresponding to inputted each bit line pair BT00/BB00 and BT01/BB01. The column lines COL0 and COL1 are coupled to the switch transistors MT00 and MB00 and the switch transistors MT01 and MB01, respectively, select one bit line pair from the bit line pairs BT00/BB00 and BT01/BB01 inputted into the column selector 15_0, and input the selected bit line pair into the differential sense amplifier 16_0 as a differential pair BT0/BB0.

In the same manner as the word line decoder circuit 12, the column line decoder circuit 14 is formed by a circuit as illustrated in Fig. 3 and indicates a failure mode as illustrated in Fig. 4. In other words, a failure of the column line decoder circuit 14 appears as a multiple selection or a non-selection of the column lines COL.

As an example of the multiple selection of the column line COL, a case in which both the COL0 and COL1 are asserted in Fig. 5 will be described. In one input BT0 of the differential sense amplifier 16_0, signals from the BT00 and BT01 collide with each other, and in the other input BB0, signals from the BB00 and BB01 collide with each other. As a result, the read-out data of the sense amplifier 16_0 becomes random data.

As an example of the non-selection of the column line COL, a case in which all the column lines including COL0 and COL1 are negated in Fig. 5 will be described. All the switch transistors MT00, MB00, MT01, and MB01 are turned off and the inputs BT0 and BB0 of the differential sense amplifier 16_0 are not driven by any memory cell. As a result, the input of the sense amplifier 16_0 is not uniquely determined, so that the read-out data becomes random data.

Therefore, also during the multiple selection and the non-selection of the column lines, the read-out data becomes random data in the same manner as in the first embodiment. Therefore, it is possible to detect a failure of multiple selection of the column lines by replacing F3 in the failure detection flow shown in Fig. 1 with F7 described below.

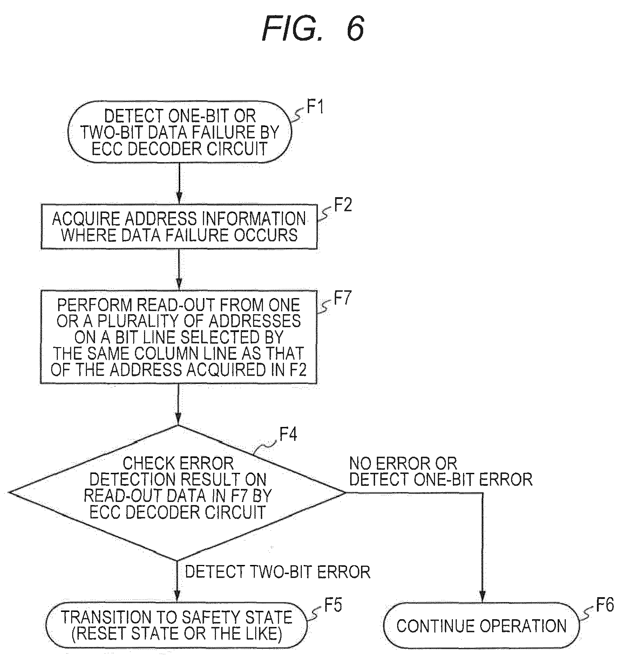

Fig. 6 is a flowchart showing a failure diagnosis flow of the second embodiment. In this failure diagnosis flow, F7 following F2 is defined as "Perform read-out from one or a plurality of addresses on a bit line selected by the same column line as that of the address acquired in F2". The other steps are the same as those in Fig. 1, so that the description thereof will be omitted.

Thereby, it is possible to improve a failure detection rate of the column line decoder circuit.

### Third Embodiment

### Read-out from a plurality of addresses sharing the same word line or the same column line

While the failure diagnosis flow is described which focuses attention on the word line decoder circuit 12 in the first embodiment and focuses attention on the column line decoder circuit 14 in the second embodiment, it is possible to combine these embodiments.

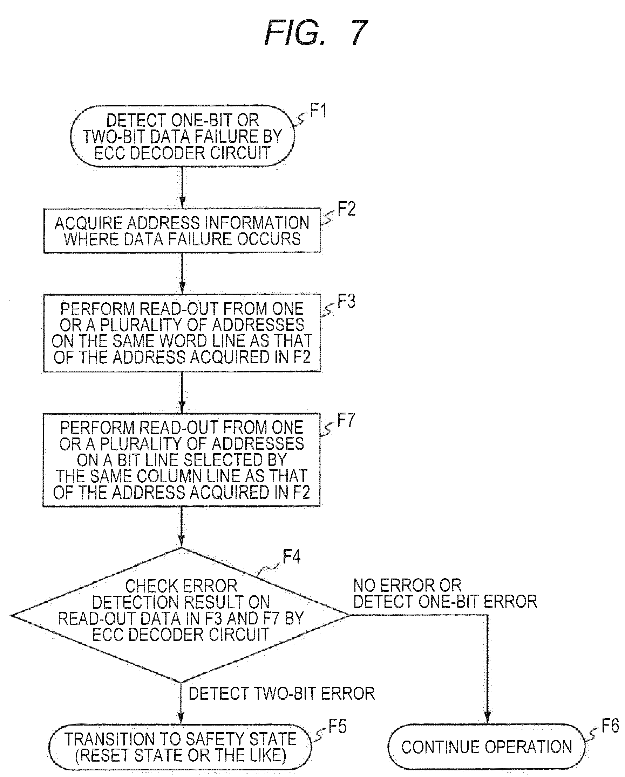

Fig. 7 is a flowchart showing a failure diagnosis flow of the third embodiment. In the same manner as in the first embodiment, following F2 of the failure diagnosis flow of the first embodiment shown in Fig. 1, F3 is performed to improve the failure detection rate of the word line decoder circuit 12, and further, in the same manner as in the second embodiment, F7 is performed to improve the failure detection rate of the column line decoder circuit 14. The other steps are the same as those in Figs. 1 and 6, so that the description thereof will be omitted.

Thereby, it is possible to improve the failure detection rate of the entire address decoder circuit including the word line decoder circuit and the column line decoder circuit.

The failure diagnosis flow described above is not limited to the memory configuration illustrated in Fig. 2, but can be widely applied to a memory in which data of addresses different from each other and redundant bits added to the data are stored in a plurality of memory cells which share the same selection signal wiring. In such a memory, data corresponding to a specified address and redundant bits added to the data are read as the read-out data and error detection processing is performed by the ECC decoder circuit. When an error is detected by the ECC decoder circuit, the diagnostic program reads out data of another address from other memory cells selected by the same selection signal wiring as the selection signal wiring that selects read-out data where the error is detected and performs error detection on the read-out data by the ECC decoder circuit. The diagnostic program evaluates a result of the error detection and determines whether the operation can be continued or the operation should be transitioned to a safety state. In the first to the third embodiments, a case in which the selection signal wirings are word lines and the column lines has been described. However it is not limited to this. In general, it is possible to apply the same failure detection flow to a memory in which read-out data from a plurality of addresses stored in a plurality of memory cells that shares the same selection signal wiring is random data or specific data where an error can be detected when the selection signal wirings are multiple selected or not selected.

Thereby, it is possible to improve a failure detection rate of an address circuit of a memory without using address information to generate redundant bits and without rewriting the memory.

### Fourth Embodiment

### Combination of ECC to address

In the first to the third embodiments, an example is described in which redundant bits are added to data to be stored in a memory and the redundant bits are used for error correction and error detection. On the other hand, it is possible to generate redundant bits from information including not only data but also address and use the redundant bits for error correction and error detection.

Thereby, it is possible to detect not only multiple selection and non-selection but also mis-selection, so that it is possible to further improve the detection rate.

### Fifth Embodiment

### Memory test circuit

In the first to the third embodiments, an example is described in which the failure detection flows illustrated in Figs. 1, 6, and 7 are realized by a program (software) executed by CPU 3 . However, an equivalent function may be realized by a memory test circuit (hardware).

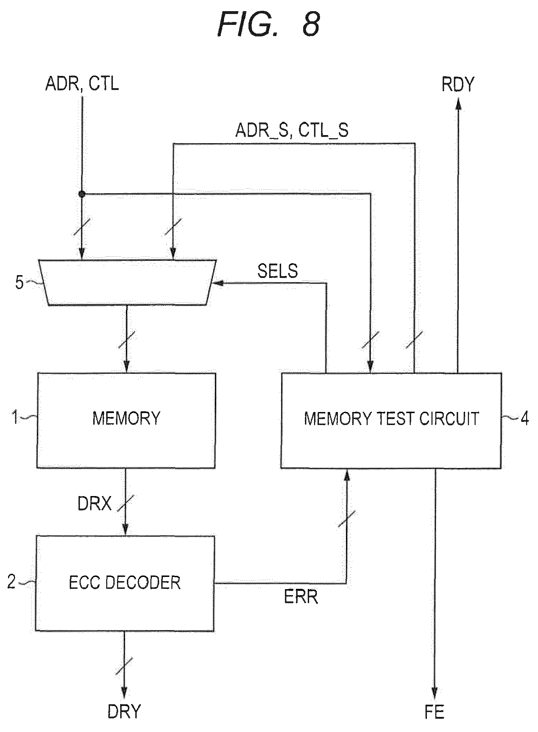

Fig. 8 is a block diagram showing an implementation example of the memory test circuit of the fifth embodiment. The memory 1 that is an object of the failure diagnosis is coupled to the ECC decoder circuit 2, a memory test circuit 4, and an address selector 5 . An address ADR and a control signal CTL for accessing the memory 1 from an external bus master such as a CPU are inputted into the memory 1 through the address selector 5 in a normal operation. Here, the bus master, which is not shown in Fig. 8, is an access main body such as a CPU which accesses the memory 1. Read-out data DRX which includes a data main body and redundant bits and which is read out from the memory 1 is inputted into the ECC decoder circuit 2, ECC-processed read-out data DRY is outputted to the bus master, and an error signal ERR that notifies of an error is outputted to the memory test circuit 4. In the same manner as in the first embodiment, an error correction algorithm employed by the ECC decoder circuit 2 is, for example, SEC/DED. The circuit configuration of the memory 1 is not limited in particular, but is, for example, as illustrated in Fig. 2. The error signal ERR is a signal that notifies of a one-bit error or a two-bit error detected by the ECC decoder circuit 2. The address ADR for the bus master to access the memory 1 is inputted into the memory test circuit 4, and when a detection of error is notified by the error signal ERR, read-out from a plurality of addresses stored in a plurality of memory cells that share the same selection signal wiring is performed. In other words, the memory test circuit 4 performs one or both of read-out of data from a plurality of different addresses on the same word line as that of the address ADR and read-out from one or a plurality of addresses on a bit line selected by the same column line as that of the address ADR. These read-out operations are performed by supplying an address ADR_S and a control signal CTL_S to the memory 1 through the address selector 5, error detection processing is performed by the ECC decoder circuit 2 on data read out by the access, and a result of the error detection processing is monitored through the error signal ERR. During the memory test, the memory 1 cannot be accessed from the bus master, so that the bus master is notified that the memory 1 is in a busy state by a ready signal RDY. When a two-bit error occurs at least once during the memory test, it is determined that an uncorrectable data error occurs, an uncorrectable error signal FE (Fatal Error) is notified to the system, and the MCU is transitioned to a safety state. Although the definition of the safety state varies according to a system, the safety state is a reset state of the MCU, a state in which an error has been notified to the system, and the like.

Thereby, it is possible to improve a failure detection rate of the address circuit of the memory without applying a load to the CPU.

The memory 1, the ECC decoder circuit 2, and the CPU 3 or the memory test circuit 4 are not limited in particular, but, for example, are formed over a single semiconductor substrate such as silicon by using a known CMOS (Complementary Metal-Oxide-Semiconductor field effect transistor) semiconductor manufacturing technique. It may be configured so that a combination of a plurality of memories 1 and the ECC decoder circuit 2 is mounted over the same LSI (Large Scale Integrated circuit) and the failure detection processing as described in each embodiment is performed by the single CPU 3 or the single memory test circuit 4. The failure diagnostic program executed by the CPU 3 may be provided by being stored in a ROM such as a flash memory on the same LSI or may be transferred to an on-chip RAM by a boot program at power-on.

While the invention made by the inventors has been specifically described based on the embodiments, it is needless to say that the present invention is not limited to the embodiments and may be variously modified without departing from the scope of the invention.

For example, the memory employs hierarchical word lines and hierarchical bit lines, so that even when a plurality of addresses are selected by a selection signal wiring other than a word line and a column line, the diagnostic program, the diagnostic method, or the memory test circuit can be changed so as to deal with the failure diagnosis of the memory. Further, the ECC implemented in the ECC decoder can be changed to an error correction algorithm other than SEC/DED. For example, an error detection using parity may be employed instead of ECC. Further, the ECC decoder circuit may be changed to a configuration in which ECC processing equivalent to processing of the ECC decoder circuit is performed by software. As a configuration of the memory, a data storage system may be employed in which data and redundant data are distributed and stored in a plurality of physically divided memories. In other words, when at least a part of data of addresses different from each other and redundant bits added to the data is stored in a plurality of memory cells sharing the same selection signal wiring, the entire data and redundant bits added to the data may be distributed and stored in a plurality of memories or memory mats.

## Claims

1. A diagnostic program which is executed by a processor that can access a memory to which an ECC decoder is coupled and which diagnoses a failure of the memory,
wherein the memory stores data of addresses different from each other and redundant bits added to the data in a plurality of memory cells sharing the same selection signal wiring and outputs data corresponding to a specified address and redundant bits added to the data as read-out data,
wherein the ECC decoder performs error detection on read-out data that is read out from the memory, and
wherein the diagnostic program includes
a related address read-out step of, when an error is detected by the ECC decoder, reading out another read-out data from other memory cells selected by the same selection signal wiring as selection signal wiring that selects read-out data where the error is detected, and
an evaluation step of evaluating a result of error detection performed by the ECC decoder for the other read-out data that is read out in the related address read-out step.

2. The diagnostic program according to claim 1,
wherein the memory includes a plurality of word lines, a plurality of column lines, a plurality of bit lines or bit line pairs, a plurality of memory cells, and a plurality of sense amplifiers,
wherein a plurality of memory cells whose addresses are different from each other are selected by one of the word lines or one of the column lines,
wherein data selected by a column line from a plurality of data that are read out from the selected memory cells through the bit lines or the bit line pairs is outputted as the read-out data through a sense amplifier, and
wherein when an error is detected by the ECC decoder, the related address read-out step reads out read-out data of one or a plurality of addresses different from an address of read-out data where the error is detected from the other memory cells coupled to the same word line as a word line that selects the read-out data where the error is detected.

3. The diagnostic program according to claim 1,
wherein the memory includes a plurality of word lines, a plurality of column lines, a plurality of bit lines or bit line pairs, a plurality of memory cells, and a plurality of sense amplifiers,
wherein a plurality of memory cells whose addresses are different from each other are selected by one of the word lines or one of the column lines,
wherein data selected by a column line from a plurality of data that are read out from the selected memory cells through the bit lines or the bit line pairs is outputted as the read-out data through a sense amplifier, and
wherein when an error is detected by the ECC decoder, the related address read-out step reads out read-out data of one or a plurality of addresses different from an address of read-out data where the error is detected from the other memory cells coupled to the same bit line or bit line pair as a bit line or a bit line pair selected by a column line that selects the read-out data where the error is detected.

4. The diagnostic program according to claim 1,
wherein the memory includes a plurality of word lines, a plurality of column lines, a plurality of bit lines or bit line pairs, a plurality of memory cells, and a plurality of sense amplifiers,
wherein a plurality of memory cells whose addresses are different from each other are selected by one of the word lines or one of the column lines,
wherein data selected by a column line from a plurality of data that are read out from the selected memory cells through the bit lines or the bit line pairs is outputted as the read-out data through a sense amplifier, and
wherein when an error is detected by the ECC decoder, the related address read-out step reads out read-out data of one or a plurality of addresses different from an address of read-out data where the error is detected from the other memory cells coupled to the same word line as a word line that selects the read-out data where the error is detected and reads out read-out data of one or a plurality of addresses different from the address of read-out data where the error is detected from the other memory cells coupled to the same bit line or bit line pair as a bit line or a bit line pair selected by a column line that selects the read-out data where the error is detected.

5. The diagnostic program according to claim 1,
wherein the ECC decoder can detect and correct one-bit error in read-out data and can detect two-bit error in read-out data, and
wherein the diagnostic program further includes a step of transitioning to a safety state when the ECC decoder detects a two-bit error in at least one of the read-out data and the other read-out data.

6. A diagnostic method for diagnosing a failure of a memory to which an ECC decoder is coupled,
wherein the memory stores data of addresses different from each other and redundant bits added to the data in a plurality of memory cells sharing the same selection signal wiring and outputs data corresponding to a specified address and redundant bits added to the data as read-out data,
wherein the ECC decoder performs error detection on read-out data that is read out from the memory, and
wherein the diagnostic method includes
a related address read-out step of, when an error is detected by the ECC decoder, reading out another read-out data from other memory cells selected by the same selection signal wiring as selection signal wiring that selects read-out data where the error is detected, and
an evaluation step of evaluating a result of error detection performed by the ECC decoder for the other read-out data that is read out in the related address read-out step.

7. The diagnostic method according to claim 6,
wherein the memory includes a plurality of word lines, a plurality of column lines, a plurality of bit lines or bit line pairs, a plurality of memory cells, and a plurality of sense amplifiers,
wherein a plurality of memory cells whose addresses are different from each other are selected by one of the word lines or one of the column lines,
wherein data selected by a column line from a plurality of data that are read out from the selected memory cells through the bit lines or the bit line pairs is outputted as the read-out data through a sense amplifier, and
wherein when an error is detected by the ECC decoder, the related address read-out step reads out read-out data of one or a plurality of addresses different from an address of read-out data where the error is detected from the other memory cells coupled to the same word line as a word line that selects the read-out data where the error is detected.

8. The diagnostic method according to claim 6,
wherein the memory includes a plurality of word lines, a plurality of column lines, a plurality of bit lines or bit line pairs, a plurality of memory cells, and a plurality of sense amplifiers,
wherein a plurality of memory cells whose addresses are different from each other are selected by one of the word lines or one of the column lines,
wherein data selected by a column line from a plurality of data that are read out from the selected memory cells through the bit lines or the bit line pairs is outputted as the read-out data through a sense amplifier, and
wherein when an error is detected by the ECC decoder, the related address read-out step reads out read-out data of one or a plurality of addresses different from an address of read-out data where the error is detected from the other memory cells coupled to the same bit line or bit line pair as a bit line or a bit line pair selected by a column line that selects the read-out data where the error is detected.

9. The diagnostic method according to claim 6,
wherein the memory includes a plurality of word lines, a plurality of column lines, a plurality of bit lines or bit line pairs, a plurality of memory cells, and a plurality of sense amplifiers,
wherein a plurality of memory cells whose addresses are different from each other are selected by one of the word lines or one of the column lines,
wherein data selected by a column line from a plurality of data that are read out from the selected memory cells through the bit lines or the bit line pairs is outputted as the read-out data through a sense amplifier, and
wherein when an error is detected by the ECC decoder, the related address read-out step reads out read-out data of one or a plurality of addresses different from an address of read-out data where the error is detected from the other memory cells coupled to the same word line as a word line that selects the read-out data where the error is detected and reads out read-out data of one or a plurality of addresses different from the address of read-out data where the error is detected from the other memory cells coupled to the same bit line or bit line pair as a bit line or a bit line pair selected by a column line that selects the read-out data where the error is detected.

10. The diagnostic method according to claim 6,
wherein the ECC decoder can correct one-bit error in read-out data and can detect two-bit error in read-out data, and
wherein the diagnostic method further includes a step of transitioning to a safety state when the ECC decoder detects a two-bit error in at least one of the read-out data and the other read-out data.

11. A semiconductor device comprising:
an ECC decoder, a memory to which the ECC decoder is coupled, and a memory test circuit,
wherein the memory stores data of addresses different from each other and redundant bits added to the data in a plurality of memory cells sharing the same selection signal wiring and can output data corresponding to an address specified by an external device or the memory test circuit and redundant bits added to the data as read-out data,
wherein the ECC decoder can perform error detection on read-out data that is read out from the memory,
wherein the memory test circuit supplies an address to the memory to cause the memory to output read-out data and the ECC decoder inputs a result of the error detection for read-out data corresponding to the supplied address into the memory test circuit, and
wherein when an error is detected by the ECC decoder for read-out data corresponding to an address specified from outside to the memory, the memory test circuit reads out other read-out data corresponding to an address different from the address specified from the outside from other memory cells selected by the same selection signal wiring as selection signal wiring that selects the read-out data where the error is detected and evaluates a result of error detection performed by the ECC decoder for the other read-out data.

12. The semiconductor device according to claim 11,
wherein the memory includes a plurality of word lines, a plurality of column lines, a plurality of bit lines or bit line pairs, a plurality of memory cells, and a plurality of sense amplifiers,
wherein a plurality of memory cells whose addresses are different from each other are selected by one of the word lines or one of the column lines,
wherein data selected by a column line from a plurality of data that are read out from the selected memory cells through the bit lines or the bit line pairs is outputted as the read-out data through a sense amplifier, and
wherein when an error is detected by the ECC decoder for read-out data corresponding to an address specified from outside to the memory, the memory test circuit reads out other read-out data corresponding to an address different from the address specified from the outside from other memory cells coupled to the same word line as a word line that selects the read-out data where the error is detected and evaluates a result of error detection performed by the ECC decoder for the other read-out data.

13. The semiconductor device according to claim 11,
wherein the memory includes a plurality of word lines, a plurality of column lines, a plurality of bit lines or bit line pairs, a plurality of memory cells, and a plurality of sense amplifiers,
wherein a plurality of memory cells whose addresses are different from each other are selected by one of the word lines or one of the column lines,
wherein data selected by a column line from a plurality of data that are read out from the selected memory cells through the bit lines or the bit line pairs is outputted as the read-out data through a sense amplifier, and
wherein when an error is detected by the ECC decoder for read-out data corresponding to an address specified from outside to the memory, the memory test circuit reads out other read-out data corresponding to an address different from the address specified from the outside from other memory cells coupled to the same bit line or bit line pair as a bit line or a bit line pair selected by a column line that selects the read-out data where the error is detected and evaluates a result of error detection performed by the ECC decoder for the other read-out data.

14. The semiconductor device according to claim 11,
wherein the memory includes a plurality of word lines, a plurality of column lines, a plurality of bit lines or bit line pairs, a plurality of memory cells, and a plurality of sense amplifiers,
wherein a plurality of memory cells whose addresses are different from each other are selected by one of the word lines or one of the column lines,
wherein data selected by a column line from a plurality of data that are read out from the selected memory cells through the bit lines or the bit line pairs is outputted as the read-out data through a sense amplifier, and
wherein when an error is detected by the ECC decoder for read-out data corresponding to an address specified from outside to the memory, the memory test circuit reads out other read-out data corresponding to an address different from the address specified from the outside from memory cells coupled to the same word line as a word line that selects the read-out data where the error is detected, further reads out other read-out data corresponding to an address different from the address specified from the outside from other memory cells coupled to the same bit line or bit line pair as a bit line or a bit line pair selected by a column line that selects the read-out data where the error is detected, and evaluates a result of error detection performed by the ECC decoder for the other read-out data and the other read-out data that is further read out.

15. The semiconductor device according to claim 11,
wherein the memory test circuit includes a processer that can access the memory and a program memory that stores a diagnostic program which is executed by the processor and which diagnoses a failure of the memory.

16. The semiconductor device according to claim 11,
wherein the ECC decoder can correct one-bit error in read-out data and can detect two-bit error in read-out data, and
wherein the memory test circuit outputs an error detection signal to transition the semiconductor device to a safety state when the ECC decoder detects a two-bit error in at least one of the read-out data and the other read-out data.

17. The semiconductor device according to claim 11,
wherein the semiconductor device is formed over a single semiconductor substrate.
